# EUROPEAN PATENT SPECIFICATION

(11) **EP 0 400 724 B1**
(45) Date of publication and mention of the grant of the patent: **23.08.1995**
(21) Application number: 90201307.7
(22) Date of filing: 23.05.1990
(51) Int. Cl.: G11C 7/06, G11C 11/419

(54) **Integrated memory comprising a sense amplifier**
Integrierte Speicherschaltung mit einem Leseverstärker
Circuit intégré de mémorisation muni d'un amplificateur de lecture

(30) Priority: 29.05.1989 NL 8901344
(43) Date of publication of application: 05.12.1990
(73) Proprietor: Philips Electronics N.V., 5621 BA Eindhoven (NL)
(72) Inventor: Seevinck, Evert, NL-5656 AA Eindhoven (NL)
(74) Representative: Strijland, Wilfred

(56) References cited:
- US-A- 4 069 475
- US-A- 4 123 799
- US-A- 4 479 202
- ISSCC, IEEE INTERNATIONAL SOLID-STATE CONFERENCE, 20th February 1976, New York,US; M.R. GUIDRY et al.: "A sense amplifier for a low clock capacitance 16K CCDmemory"

## Description

The invention relates to an integrated field-effect transistor memory comprising a sense amplifier which includes a parallel connection of a first and a second current branch, each current branch comprising a channel of a control transistor and a channel of a load transistor, which channels are coupled via a relevant junction point, the junction point in each current branch being coupled to the gate of the load transistor in the other current branch, at least one of said junction points constituting an output of said sense amplifier, said transistors being of the same conductivity type, the control transistors being connected in a source follower configuration, the relevant load transistor being connected to the source of the relevant control transistor.

Such an integrated field transistor memory is known from US 4,069,475 and also from US 4,123,799. When the sense amplifier according to these publications is turned on it develops a voltage at the output in response to an input signal presented at the gates of the control transistors. The sense amplifier latches the voltage at the output into a stable state, in which the voltage at the output is kept at an extreme corresponding to one of the supply voltages.

US 4,479,202 describes a memory circuit in which, in a sense amplifier of a different latching type, the load transistors are shared among a number of sense amplifiers. In this case, each sense amplifier contains additional transistors to connect only one active sense amplifier to the load transistors.

When a new input signal must be sensed, the prior art amplifier must be restored. For this purpose its junction points are connected via the channel of a restore transistor. In order to restore the sense amplifier a restore signal is applied to the gate of the restore transistor, to make its channel conductive.

The need to restore the sense amplifier is disadvantageous because it requires a restore transistor, and carefully timed signals for selecting the sense amplifier.

From JP Kokai 61-96587 an integrated field effect transistor memory is known in which the control transistor are of N-type and the load transistors are of P-type.

The bit line voltages in integrated memory circuits usually approximate the positive supply voltage. Consequently, sense amplifiers of this kind have the drawback that the voltages on the drains of the transistors Q1 and Q2 may decrease only from 1 to 2 V below the positive supply voltage in order to ensure that the control transistors Q1 and Q2 are operative exclusively in the saturation zone as to achieve an as fast as possible sense amplifier. In the event of disturbances (VDD bumps) in the positive supply voltage in the negative direction in the known sense amplifiers, however, the setting of at least one of the transistors Q1 and Q2 will still leave the saturation zone, so that such sense amplifiers become slower.

It is an object of the invention to provide for an integrated memory circuit which does not require signals for restoring it.

It is a further object of the invention to provide for an integrated memory circuit, which is fast and whose speed is relatively unaffected by negative bumps on the positive supply voltage.

To achieve this, an integrated memory circuit according to the invention is characterized, in that the transistors are dimensioned such that a width length ratio (W/L) of the load transistor in each current branch is no more than twice the width length ratio (W/L) of the control transistor in the relevant current branch, whereby in operation the output of the sense amplifier is not latched to a supply voltage, the voltage on the output following the input signal on a gate of the control transistors when a new input signal is presented.

Thus, the sense amplifier in accordance with the invention is of the self restoring type, i.e. the voltage on the output of the sense amplifier automatically follows the voltage on its input when a new input signal is presented.

Another embodiment of an integrated memory in accordance with the invention is characterized in that said width/length ratios (W/L) are substantially equal. As a result, the same dimensions can be chosen for the load transistors and the control transistors, so that the chip lay-out of such a sense amplifier is very simple.

Another embodiment of an integrated memory, comprising several sense amplifiers which are connected to a same bus at the output side, and also comprising a selection circuit for selecting a single sense amplifier in accordance with the invention, is characterized in that the selection circuit comprises a first and a second selection transistor in each sense amplifier, a channel of said selection transistors being included in the first and the second current branch, respectively, between a supply terminal on the one side and a drain of the respective control transistor on the other side, the coupled gates of said selection transistors receiving a selection signal for the selective activation of a single sense amplifier. When a desired sense amplifier is selected, the relevant selection transistors are driven to full output so that the drains of the control transistors receive the entire or substantially the entire supply voltage. As a result, these transistors continue to operate in the saturation region.

The invention will be described in detail hereinafter with reference to the embodiments shown in the drawing; therein:
Fig. 1 shows an embodiment of a sense amplifier in accordance with the invention, and
Fig. 2 shows an embodiment of an integrated memory comprising several sense amplifiers in accordance with the invention.

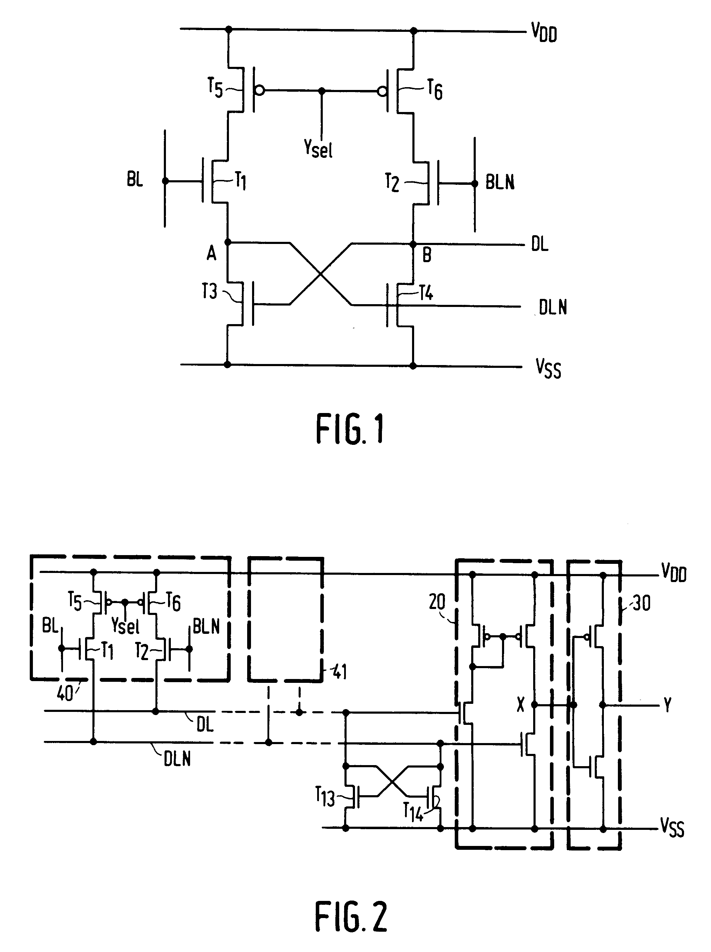

Fig. 1 shows an embodiment of a sense amplifier in accordance with the invention. The sense amplifier comprises 4 NMOS-transistors T1, T2, T3 and T4 and 2 PMOS-transistors T5 and T6. The sources of selection transistors T5 and T6 are connected to a supply terminal VDD, the drains of these transistors being connected to the drains of respective control transistors T1 and T2. The sources of the control transistors T1 and T2 are connected to respective junction points A and B and the drains of respective load transistors T3 and T4. The sources of the load transistors T3 and T4 are connected to a supply terminal VSS. The gates of the selection transistors T5 and T6 receive a selection signal YSEL, the gates of the load transistors T3 and T4 being connected to respective junction points B and A. The gates of the control transistors T1 and T2 are coupled to bit lines BL and BLN. The bit lines BL and BLN themselves are connected to memory cells in a memory column which are not shown in the Figure. The selection transistors T5 and T6, however, may also be N-type transistors if their gates receive a sufficiently high selection voltage upon selection of the sense amplifier.

The operation of the circuit shown in Fig. 1 is as follows: when the selection signal YSEL for selecting the sense amplifier shown is logic low, the selection transistors T5 and T6 are turned on. The drains of the control transistors T1 and T2 thus receive the entire or substantially the entire supply voltage VDD. The transistors T1 and T2 are connected as source-followers. The input signals on the bit lines BL and BLN are amplified by means of the transistors T1, T2 and T3, T4 and are available on the junction points A and B. Being source-followers, the transistors T1 and T2 have a gain of approximately 1, but the cross-wise coupled transistors T3 and T4 transfer the signals on the bit lines BL and BLN to the junction points A and B in amplified form still. If the width/length ratio (W/L) of the transistors T3 and T4 are no more than twice as large as the W/L ratios of the transistors T1 and T2, the sense amplifier will amplify the signals on the bit lines BL and BIN so that on the output (the junction points A and B) of the sense amplifier the voltages will not be latched to the supply voltage VDD and VSS, or VSS and VDD, respectively. This offers the advantage that such a sense amplifier is a self-restoring type. This means that the voltage on the output of the sense amplifier automatically follows the voltage on its input when a new input signal is presented. Consequently, a sense amplifier in accordance with the invention is faster, because the switching-on and off of the sense amplifier by means of a control signal, as in the sense amplifier described in the cited Japanese reference, can be dispensed with.

Fig. 2 shows an embodiment of an integrated memory comprising several sense amplifiers 40, 41 etc. in accordance with the invention. Elements in Fig. 2 which correspond to elements of Fig. 1 are denoted by corresponding references. The outputs of the sense amplifiers 40, 41 etc. are connected to the common data lines DL and DIN. The sense amplifiers 41, etc. are constructed in the same way as the sense amplifier 40. The cross-wise coupled transistors T13 and T14, analogous to T3 and T4 shown in Fig. 1, are provided only once in this circuit and are coupled to the data lines DL and DIN. Furthermore, a further amplifier stage 20 is connected to the data lines DL and DLN. A buffer circuit 30 which produces an output signal on output Y is connected to output X of the amplifier stage 20.

The operation of the circuit shown in Fig. 2 is as follows: after the selection of a single, desired sense amplifier by means of a selection signal YSEL, the bit line signals of the relevant memory column are applied to the transistors T13 and T14 via the data lines DL and DLN. The signals on these data lines are amplified by the transistors T13 and T14 and applied to the further amplifier stage 20. In this amplifier stage the signals are further amplified and applied to a buffer circuit 30 via the output X. The output Y of the buffer circuit 30 supplies an output signal having CMOS output levels. Because the transistors T13 and T14 are provided only once for several sense amplifiers connected to the data lines DL and DLN, these sense amplifiers comprise only a small number of components so that they require only a small chip surface area and readily fit in the "pitch" of a memory column.

## Claims

1. An integrated field-effect transistor memory comprising a sense amplifier which includes a parallel connection of a first and a second current branch, each current branch comprising a channel of a control transistor (T1, T2) and a channel of a load transistor (T3, T4), which channels are coupled via a relevant junction point (A, B), the junction point (A,B) in each current branch being coupled to the gate of the load transistor (T3, T4) in the other current branch, at least one of said junction points (A, B) constituting an output (DL, DLN) of said sense amplifier, said transistors (T1, T2, T3, T4) being of the same conductivity type, the control transistors (T1, T2) being connected in a source follower configuration, the relevant load transistor (T3, T4) being connected to the source of the relevant control transistor (T1, T2), characterized, in that the transistors (T1, T2, T3, T4) are dimensioned such that a width length ratio (W/L) of the load transistor (T3, T4) in each current branch is no more than twice the width length ratio (W/L) of the control transistor in the relevant current branch, whereby in operation the output (DL, DLN) of the sense amplifier is not latched to a supply voltage (Vss, Vdd), the voltage on the output (DL, DLN) following the input signal on a gate of the control transistors (BL, BLN) when a new input signal is presented.

2. An integrated field-effect transistor memory circuit as claimed in Claim 1, characterized in that said width/length ratios (W/L) are substantially equal.

3. An integrated field-effect transistor memory circuit as claimed in Claim 1 or 2, comprising several sense amplifiers (40, 41) which are connected to the same bus (DL, DLN) at the output side, and also comprising a selection circuit (T5, T6) for selecting a single sense amplifier (40, 41), further characterized in that the selection circuit comprises a first and a second transistor (T5, T6) in each sense amplifier (40, 41), a channel of said first and second transistors (T5, T6) being included in the first and the second current branch, respectively, between a supply terminal (Vdd) on the side and a drain of the respective control transistor (T1, T2) on the other side, the coupled gates of said first and second transistors (T5, T6) receiving a selection signal (Ysel) for the selective activation of a single sense amplifier (40, 41).

4. An integrated field-effect transistor memory circuit as claimed in Claim 1, 2 or 3, characterized in that the memory circuit comprises several sense amplifiers (40, 41) which together comprise one common pair of load transistors (T3, T4), the load transistors being coupled between the bus (DL, DLN) and a first supply terminal (Vss), there being provided a selection circuit (T5, T6) for the selective activation of a single sense amplifier (40, 41).

5. An integrated field-effect transistor memory circuit as claimed in Claim 4, in which the selection circuit comprises selection transistors (T5, T6), characterized in that channels of the relevant selection transistors (T5, T6) are connected between a drain of the relevant control transistor (T1, T2) and a second supply terminal (Vdd).

## Patentansprüche

1. Integrierter Feldeffekttransistor-Speicher mit einem Leseverstärker, der eine Parallelschaltung aus einem ersten und einem zweiten Stromzweig umfaßt, wobei jeder Stromzweig einen Kanal eines Steuertransistors (T1, T2) und einen Kanal eines Lasttransistors (T3, T4) umfaßt, welche Kanäle über einen betreffenden Knotenpunkt (A, B) gekoppelt sind, wobei der Knotenpunkt (A, B) in jedem Stromzweig mit dem Gate des Lasttransistors (T3, T4) in dem anderen Stromzweig gekoppelt ist, mindestens einer der genannten Knotenpunkte (A, B) einen Ausgang (DL, DLN) des genannten Leseverstärkers bildet, wobei die genannten Transistoren (T1, T2, T3, T4) vom gleichen Leitungstyp sind, der Steuertransistor (T1, T2) in einer Source-Folger-Konfiguration geschaltet ist, der betreffende Lasttransistor (T3, T4) mit der Source des betreffenden Steuertransistors (T1, T2) verbunden ist, dadurch gekennzeichnet, daß die Transistoren (T1, T2, T3, T4) so dimensioniert sind, daß ein Breiten/Längen-Verhältnis (W/L) des Lasttransistors (T3, T4) in jedem Stromzweig nicht mehr als zweimal so groß wie das Breiten/Längen-Verhältnis (W/L) des Steuertransistors in dem betreffenden Stromzweig ist, wodurch im Betrieb der Ausgang (DL, DLN) des Leseverstärkers nicht mit einer Versorgungsspannung (Vss, Vdd) verriegelt ist, wobei die Spannung am Ausgang (DL, DLN) dem Eingangssignal an einem Gate des Steuertransistors (BL, BLN) folgt, wenn ein neues Eingangssignal angeboten wird.

2. Integrierte Feldeffekttransistor-Speicherschaltung nach Anspruch 1, dadurch gekennzeichnet, daß die genannten Breiten/Längenverhältnisse (W/L) nahezu gleich sind.

3. Integrierte Feldeffekttransistor-Speicherschaltung nach Anspruch 1 oder 2, mit mehreren Leseverstärkern (40, 41), die an der Ausgangsseite mit dem gleichen Bus (DL, DLN) verbunden sind, und auch mit einer Selektionsschaltung (T5, T6) zur Selektion eines einzelnen Leseverstärkers (40, 41), weiterhin dadurchgekennzeichnet, daß die Selektionsschaltung einen ersten und einen zweiten Transistor (T5, T6) in jedem Leseverstärker (40, 41) umfaßt, wobei ein Kanal dieses ersten und zweiten Transistors (T5, T6) zwischen einem Versorgungsanschluß (vdd) einerseits und einem Drain des jeweiligen Steuertransistors (T1, T2) andererseits in den ersten bzw. den zweiten Stromzweig aufgenommen ist, wobei die gekoppelten Gates dieses ersten und zweiten Transistors (T5, T6) ein Selektionssignal (Ysel) für die selektive Aktivierung eines einzelnen Leseverstärkers (40, 41) empfangen.

4. Integrierte Feldeffekttransistor-Speicherschaltung nach Anspruch 1, 2 oder 3, dadurch gekennzeichnet, daß die Speicherschaltung mehrere Leseverstärker (40, 41) umfaßt, die zusammen ein einzelnes gemeinsames Paar von Lasttransistoren (T3, T4) umfassen, wobei die Lasttransistoren zwischen den Bus (DL, DLN) und einen ersten Versorgungsanschluß (Vss) geschaltet sind, wobei eine Selektionsschaltung (T5, T6) zur selektiven Aktivierung eines einzelnen Leseverstärkers (40, 41) verschafft wird.

5. Integrierte Feldeffekttransistor-Speicherschaltung nach Anspruch 4, in der die Selektionsschaltung Selektionstransistoren (T5, T6) umfaßt, dadurch gekennzeichnet, daß Kanäle der betreffenden Selektionstransistoren (T5, T6) zwischen ein Drain des betreffenden Steuertransistors (T1, T2) und einen zweiten Versorgungsanschluß (Vdd) geschaltet sind.

## Revendications

1. Mémoire intégrée à transistors à effet de champ comprenant un amplificateur de lecture qui comprend un montage en parallèle d'une première et d'une deuxième branches de courant, chaque branche de courant comprenant un canal d'un transistor de commande (T1, T2) et un canal d'un transistor de charge (T3, T4), lesdits canaux étant couplés via un point de jonction associé (A, B), le point de jonction (A, B) de chaque branche de courant étant couplé à la grille du transistor de charge (T3, T4) de l'autre branche de courant, au moins l'un desdits points de jonction (A, B) constituant une sortie (DL, DLN) dudit amplificateur de lecture, lesdits transistors (T1, T2, T3, T4) étant du même type de conductivité, les transistors de commande (T1, T2) étant connectés selon une configuration à source suiveuse, le transistor de charge concerné (T3, T4) étant connecté à la source du transistor de commande concerné (T1, T2), caractérisée en ce que les transistors (T1, T2, T3, T4) sont dimensionnés, de telle sorte qu'un rapport largeur/longueur (W/L) du transistor de charge (T3, T4) de chaque branche de courant ne soit pas supérieur au double du rapport largeur/longueur (W/L) du transistor de commande de la branche de courant concernée, de sorte qu'en fonctionnement, la sortie (DL, DLN) de l'amplificateur de lecture n'est pas verrouillée sur une tension d'alimentation (VSS, VDD), la tension à la sortie (DL,DLN) suivant le signal d'entrée sur une grille (BL, BLN) des transistors de commande (T1, T2) lorsqu'un nouveau signal d'entrée se présente.

2. Circuit de mémoire intégré à transistors à effet de champ selon la revendication 1, caractérisé en ce que lesdits rapports largeur/longueur (W/L) sont sensiblement égaux.

3. Circuit de mémoire intégré à transistors à effet de champ selon la revendication 1 ou 2, comprenant plusieurs amplificateurs de lecture (40, 41) qui sont connectés au même bus (DL, DLN) du côté de sortie et comprenant également un circuit de sélection (T5, T6) pour sélectionner un seul amplificateur de lecture (40, 41), caractérisé, en outre, en ce que le circuit de sélection comprend un premier et un deuxième transistors (T5, T6) dans chaque amplificateur de lecture (40, 41), un canal desdits premier et deuxième transistors (T5, T6) étant inclus dans la première et la deuxième branches de courant, respectivement, entre une borne d'alimentation (VDD) d'un côté et un drain du transistor de commande respectif (T1, T2) de l'autre côté, les grilles couplées desdits premier et deuxième transistors (T5, T6) recevant un signal de sélection (YSEL) pour l'activation sélective d'un seul amplificateur de lecture (40, 41).

4. Circuit de mémoire intégré à transistors à effet de champ selon la revendication 1, 2 ou 3, caractérisé en ce que le circuit de mémoire comprend plusieurs amplificateurs de lecture (40, 41) qui constituent conjointement une paire commune de transistors de charge (T3, T4), les transistors de charge étant couplés entre le bus (DL, DLN) et une première borne d'alimentation (VSS), un circuit de sélection (T5, T6) étant prévu pour l'activation sélective d'un seul amplificateur de lecture (40, 41).

5. Circuit de mémoire intégré à transistors à effet de champ selon la revendication 4, dans lequel le circuit de sélection comprend des transistors de sélection (T5, T6), caractérisé en ce que des canaux des transistors de sélection concernés (T5, T6) sont connectés entre un drain du transistor de commande concerné (T1, T2) et une deuxième borne d'alimentation (VDD).
